# EUROPEAN PATENT APPLICATION

(11) **EP 4 741 850 A1**
(43) Date of publication of application: **13.05.2026**
(21) Application number: 25758439.1
(22) Date of filing: 19.02.2025
(51) Int. Cl.: G01R 31/382, G01R 31/392, G01R 19/12, G01R 31/396, B60L 58/12

(54) **APPARATUS AND METHOD FOR ESTIMATING CAPACITY OF BATTERY**

(30) Priority: 21.02.2024 KR 20240025269
(71) Applicant: LG Energy Solution, Ltd., Seoul 07335 (KR)
(72) Inventor: KIM, Ji-Yeon, Daejeon 34122 (KR); KIM, Young-Deok, Daejeon 34122 (KR); PARK, Jun-Cheol, Daejeon 34122 (KR); CHOI, Soon-Ju, Daejeon 34122 (KR); KIM, Dae-Soo, Daejeon 34122 (KR)
(74) Representative: Goddar, Heinz J.
(86) International application number: PCT/KR2025/002372
(87) International publication number: WO 2025/178356

(57) **Abstract**

A battery capacity estimating apparatus according to an embodiment of the present disclosure includes: a measurement unit that measures the pack capacity of a battery pack and the voltage of each of a plurality of batteries included in the battery pack during a charging-discharging process; and a control unit. The control unit is configured to calculate the relative capacity ratio among the plurality of batteries based on the voltage range of each of the plurality of batteries, and estimate the capacity of each of the plurality of batteries based on the pack capacity and the relative capacity ratio.

## Description

### TECHNICAL FIELD

This application is based on and claims priority from Korean Patent Application No. 10-2024-0025269, filed on February 21, 2024, with the Korean Intellectual Property Office, the disclosure of which is incorporated herein in its entirety by reference.

The present disclosure relates to a battery capacity estimating apparatus and method, and more specifically, to an apparatus and method for estimating the capacity of a battery.

### BACKGROUND

Recently, as the demand for portable electronic products such as notebook computers, video cameras, and portable phones has rapidly increased, and as the development of electric vehicles, energy storage batteries, robots, and satellites has begun in earnest, researches on the high-performance batteries allowing repeated charging and discharging are being actively conducted.

Currently, commercialized batteries include, for example, nickel cadmium batteries, nickel hydrogen batteries, nickel zinc batteries, and lithium batteries. Among these, lithium batteries have received considerable attention due to their advantages including a substantially low memory effect to allow a high degree of freedom in charging and discharging, a very low self-discharging rate, and high energy density, as compared to the nickel-based batteries.

Since a battery has a characteristic of degrading over time with use, it is necessary to accurately grasp the current state of the battery in order to diagnose (or predictively diagnose) the state (or lifespan) of the battery. However, after the battery is manufactured, it becomes challenging to disassemble and analyze the battery, making it difficult to accurately measure and diagnose the current state of the battery.

Accordingly, there is a demand for a technology capable of more accurately estimating the current state of a battery using a non-destructive method.

### DISCLOSURE

### Technical Problem

The present disclosure provides a battery capacity estimating apparatus and method for estimating the capacity of a battery using a non-destructive method.

Various aspects of the present disclosure may be understood through the following description and will become more apparent from the embodiments of the present disclosure. In addition, it will be readily understood that various aspects of the present disclosure may be implemented by the means and combinations thereof as described in the claims.

### Technical Solution

A battery capacity estimating apparatus according to an aspect of the present disclosure may include: a measurement unit configured to measure the pack capacity of a battery pack and the voltage of each of a plurality of batteries included in the battery pack during a charging-discharging process; and a control unit. The control unit is configured to: calculate the relative capacity ratio among the plurality of batteries based on the voltage range of each of the plurality of batteries; and estimate the capacity of each of the plurality of batteries based on the pack capacity and the relative capacity ratio.

The control unit may be configured to: determine the voltage range of each of the plurality of batteries; adjust the determined plurality of voltage ranges to correspond to each other to calculate the change ratio of each of the plurality of batteries; and calculate the relative capacity ratio of each of the plurality of batteries based on the calculated plurality of change ratios.

The control unit may be configured to: set one of the plurality of voltage ranges as a reference voltage range; and adjust the plurality of voltage ranges to correspond to the reference voltage range to calculate the plurality of change ratios.

The control unit may be configured to: calculate a range value representing the size of each of the plurality of voltage ranges; and calculate the ratio of the range value of the reference voltage range to the range value of each of the plurality of voltage ranges to calculate the plurality of change ratios.

The control unit may be configured to: set one of the plurality of change ratios as a reference change ratio; and calculate the relative capacity ratio of each of the plurality of batteries based on the plurality of change ratios and the reference change ratio.

The control unit may be configured to calculate the ratio of the reference change ratio to each of the plurality of change ratios to calculate the relative capacity ratio of each of the plurality of batteries.

The control unit may be configured to set the largest value among the plurality of change ratios as the reference change ratio.

The control unit may be configured to estimate the capacity of each of the plurality of batteries by multiplying the pack capacity by the relative capacity ratio.

The plurality of batteries may be configured to be connected in series with each other.

A battery pack according to another aspect of the present disclosure may include the battery capacity estimating apparatus according to an aspect of the present disclosure.

A vehicle according to yet another aspect of the present disclosure may include the battery capacity estimating apparatus according to an aspect of the present disclosure.

A battery capacity estimating method according to another aspect of the present disclosure may include: a measurement step of measuring the pack capacity of a battery pack and the voltage of each of a plurality of batteries included in the battery pack during a charging-discharging process; a relative capacity ratio calculation step of calculating the relative capacity ratio among the plurality of batteries based on the voltage range of each of the plurality of batteries; and a capacity estimation step of estimating the capacity of each of the plurality of batteries based on the pack capacity and the relative capacity ratio.

A non-transitory computer-readable storage medium according to another aspect of the present disclosure may have stored therein a program for executing a battery capacity estimating method that includes: a measurement step of measuring the pack capacity of a battery pack and the voltage of each of a plurality of batteries included in the battery pack during a charging-discharging process; a relative capacity ratio calculation step of calculating the relative capacity ratio among the plurality of batteries based on the voltage range of each of the plurality of batteries; and a capacity estimation step of estimating the capacity of each of the plurality of batteries based on the pack capacity and the relative capacity ratio.

### Advantageous Effects

According to an aspect of the present disclosure, even if the charging-discharging processes of the plurality of batteries are not individually performed, the capacity (maximum capacity) of each of the plurality of batteries may be accurately estimated.

The effects of the present disclosure are not limited to those mentioned above, and other effects not mentioned above will be clearly understood by persons ordinarily skilled in the art from the claims.

### BRIEF DESCRIPTION OF THE DRAWINGS

The following drawings attached hereto serve to further aid in understanding the technical spirit of the present disclosure in conjunction with the detailed description of the present disclosure described below. Therefore, the present disclosure should not be construed as being limited only to the matters illustrated in such drawings.
FIG. 1 is a view schematically illustrating a battery capacity estimating apparatus according to an embodiment of the present disclosure.
FIG. 2 is a view schematically illustrating the capacities of first to third batteries according to an embodiment of the present disclosure.
FIG. 3 is a view illustrating the capacities of first to third batteries according to an embodiment of the present disclosure in more detail.
FIG. 4 is a view schematically illustrating a battery pack according to another embodiment of the present disclosure.
FIG. 5 is a view schematically illustrating a vehicle according to another embodiment of the present disclosure.
FIG. 6 is a view schematically illustrating a battery capacity estimating method according to yet another embodiment of the present disclosure.

### DETAILED DESCRIPTION

The terms or words used in the specification and claims should not be construed as limited to their ordinary or dictionary meanings, but should be construed as having meanings and concepts consistent with the technical idea of the present disclosure based on the principle that an inventor may appropriately define the concepts of terms in order to explain his or her own invention in the best way.

Accordingly, the embodiments described in this specification and the configurations illustrated in the drawings are merely some of the exemplary embodiments of the present disclosure, and do not represent all the technical ideas of the present disclosure. Therefore, it should be understood that, at the time of filing the present application, various equivalents and modifications that can replace these embodiments may exist.

In describing the present disclosure, detailed explanations of related known functions and configurations will be omitted when it is determined that such detailed explanations may obscure the gist of the present disclosure.

Terms containing ordinal numbers, such as "first" and "second," are used to distinguish one from another among various components and are not intended to limit or define the components with such terms.

Throughout the specification, when a part is described as "including" a certain component, it means that, unless there is specific contrary wording, it does not exclude other components, but rather indicates that other components may be further included.

In addition, throughout the specification, when a part is described as being "connected" to another part, this includes not only the case where the parts are "directly connected," but also the case where the parts are "indirectly connected," with another element interposed therebetween.

Hereinafter, embodiments of the present disclosure will be described with reference to the accompanying drawings.

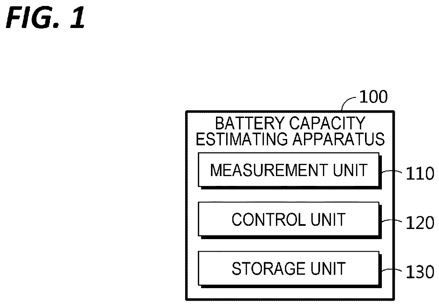

FIG. 1 is a schematic view illustrating a battery capacity estimating apparatus 100 according to an embodiment of the present disclosure.

Referring to FIG. 1, the battery capacity estimating apparatus 100 may include a measurement unit 110 and a control unit 120.

The measurement unit 110 may be configured to measure the pack capacity Qp of a battery pack and the voltage of each of a plurality of batteries included in the battery pack during a charging-discharging process. Hereinafter, for convenience of explanation, the measurement unit 110 will be described as measuring the pack capacity Qp of the battery pack and the voltage of each of the plurality of batteries during a charging process.

A battery refers to a single independent cell that includes a negative electrode terminal and a positive electrode terminal and is physically separable. For example, a lithium-ion battery or a lithium polymer battery may be considered as a battery. The types of batteries may be cylindrical type, prismatic type, or pouch type. Hereinafter, for convenience of explanation, a battery will be described as referring to a single independent cell.

For example, a battery pack may directly include a plurality of battery cells. As another example, a battery pack may include one or more battery banks and/or one or more battery modules that include a plurality of battery cells. As yet another example, a battery pack may be a battery bank or a battery module that includes a plurality of battery cells. As such, herein, a battery pack may be applied without limitation as long as it is a cell group that includes a plurality of battery cells.

The plurality of batteries included in a battery pack may be configured to be connected in series and/or in parallel. According to an embodiment, the battery pack may include the plurality of batteries connected in series.

The measurement unit 110 may calculate a charging current applied to a battery pack until the voltage (or SOC) of the battery pack reaches a preset charging completion voltage (or charging completion SOC) from a preset charging initiation voltage (or charging initiation SOC). Then, the measurement unit 110 may integrate the charging current calculated during the charging process to calculate the pack capacity Qp of the battery pack.

The measurement unit 110 may measure a first voltage and a second voltage of each of the plurality of batteries included in the battery pack. Here, the first voltage is the voltage of each battery when charging of the battery pack is initiated, and the second voltage is the voltage of each battery when charging of the battery pack is completed.

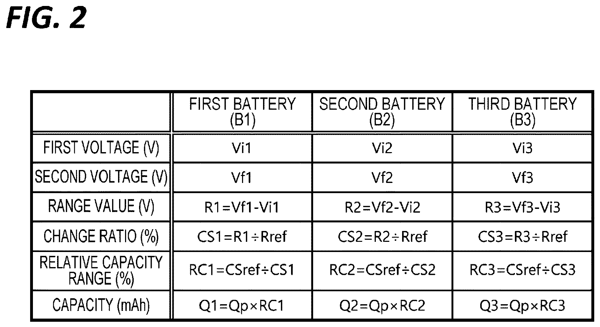

FIG. 2 is a view schematically illustrating the capacities of first to third batteries B1, B2, and B3 according to an embodiment of the present disclosure. Here, the first battery B1, the second battery B2, and the third battery B3 are battery cells included in a specific battery pack and are connected in series with each other.

Referring to FIG. 2, the first voltage of the first battery B1 is Vi1 [V], and the second voltage is Vf1 [V]. During the charging process of the battery pack, the voltage of the first battery B1 may increase from Vi1 [V] to Vf1 [V]. Similarly, the first voltage of the second battery B2 is Vi2 [V], and the second voltage is Vf2 [V]. In addition, the first voltage of the third battery B3 is Vi3 [V], and the second voltage is Vf3 [V].

According to an embodiment, since the first to third batteries B1, B2, and B3 are connected in series with each other, the capacities of the first to third batteries B1, B2, and B3 are equal to the pack capacity Qp of the battery pack.

The control unit 120 may be configured to calculate the relative capacity ratio among the plurality of batteries B1, B2, and B3 based on the voltage ranges of each of the plurality of batteries B1, B2, and B3.

According to an embodiment, the control unit 120 may be configured to determine the voltage range of each of the plurality of batteries B1, B2, and B3. Here, the voltage range refers to the voltage range of a battery during the charging-discharging process of the battery pack. For example, in the embodiment of FIG. 2, the range from the first voltage to the second voltage corresponds to the voltage range of the battery. The voltage range of the first battery B1 is Vi1 [V] to Vf1 [V], the voltage range of the second battery B2 is Vi2 [V] to Vf2 [V], and the voltage range of the third battery B3 is Vi3 [V] to Vf3 [V].

The control unit 120 may be configured to adjust the determined plurality of voltage ranges to correspond to each other and calculate the change ratio of each of the plurality of batteries B1, B2, and B3.

For example, the control unit 120 may be configured to set one of the voltage ranges of the plurality of batteries B1, B2, and B3 as a reference voltage range. Then, the control unit 120 may be configured to adjust the plurality of voltage ranges to correspond to the set reference voltage range and calculate the change ratio of each of the plurality of batteries B1, B2, and B3.

For example, the control unit 120 may adjust the first voltage and the second voltage of the plurality of voltage ranges to correspond to the first voltage and the second voltage of a preset reference voltage range and calculate the rate at which each of the plurality of voltage ranges changes during the adjustment process. For example, the change ratio is a scale factor of the voltage ranges of the plurality of batteries B1, B2, and B3 relative to the preset reference voltage range.

An embodiment in which the control unit 120 calculates the change ratio of each of the plurality of batteries B1, B2, and B3 will be described later.

The control unit 120 may be configured to calculate the relative capacity ratio of each of the plurality of batteries B1, B2, and B3 based on the calculated plurality of change ratios. Here, the relative capacity ratio represents the capacity ratio among the plurality of batteries B1, B2, and B3 in a relative manner. For example, the greater the relative capacity ratio, the larger the capacity of the corresponding battery, and the smaller the relative capacity ratio, the smaller the capacity of the corresponding battery.

According to an embodiment, the control unit 120 may be configured to set one of the plurality of change ratios as a reference change ratio CSref. Then, the control unit 120 may be configured to calculate the relative capacity ratio of each of the plurality of batteries B1, B2, and B3 based on the plurality of change ratios and the preset reference change ratio CSref.

For example, the control unit 120 may be configured to calculate the ratio of the reference change ratio CSref to each change ratio of the plurality of batteries B1, B2, and B3 and to calculate the relative capacity ratio of each battery.

In the embodiment of FIG. 2, the control unit 120 may set one of the change ratios among the change ratio CS1 of the first battery B1, the change ratio CS2 of the second battery B2, and the change ratio CS3 of the third battery B3 as the reference change ratio CSref. Then, the control unit 120 may calculate the equation "CSref ÷ CS1" to calculate the relative capacity ratio of the first battery B1 as RC1 [%]. The control unit 120 may calculate the equation "CSref ÷ CS2" to calculate the relative capacity ratio of the second battery B2 as RC2 [%]. The control unit 120 may calculate the equation "CSref ÷ CS3" to derive the relative capacity ratio of the third battery B3 as RC3 [%].

As another example, the control unit 120 may set the average value of the change ratio CS1 of the first battery B1, the change ratio CS2 of the second battery B2, and the change ratio CS3 of the third battery B3 as the reference change ratio CSref.

The control unit 120 may be configured to estimate the capacity of each of the plurality of batteries B1, B2, and B3 based on the pack capacity Qp and the relative capacity ratio.

As described above, since the plurality of batteries B1, B2, and B3 are connected in series with each other, the plurality of batteries B1, B2, and B3 may be charged by the pack capacity Qp of the battery pack. For example, at the point when charging of the battery pack is completed, the charged capacity of each of the plurality of batteries B1, B2, and B3 is the same. However, since the degree of degradation of the plurality of batteries B1, B2, and B3 may be different from each other, the capacity (maximum capacity) of each of the plurality of batteries B1, B2, and B3 may also be different. Accordingly, the control unit 120 may calculate the maximum capacity of each of the plurality of batteries B1, B2, and B3 based on the pack capacity Qp and the relative capacity ratio.

According to an embodiment, the control unit 120 may be configured to estimate the capacity of each of the plurality of batteries B1, B2, and B3 by multiplying the pack capacity Qp by the relative capacity ratio.

For example, in the embodiment of FIG. 2, it is assumed that the pack capacity of the battery pack is Qp. The control unit 120 may calculate the equation "Qp × RC1" to estimate the capacity of the first battery B1 as Q1 [mAh]. The control unit 120 may calculate the equation "Qp × RC2" to estimate the capacity of the second battery B2 as Q2 [mAh]. The control unit 120 may calculate the equation "Qp × RC3" to estimate the capacity of the third battery B3 as Q3 [mAh].

As such, the battery capacity estimating apparatus 100 according to an embodiment of the present disclosure may estimate the capacity (maximum capacity) of each of the plurality of batteries B1, B2, and B3, which are connected in series with each other, based on the pack capacity Qp and the relative capacity ratio. In addition, the battery capacity estimating apparatus 100 has the advantage of being able to accurately estimate the capacity (maximum capacity) of each of the plurality of batteries B1, B2, and B3, even without individually performing the charging-discharging process for the plurality of batteries B1, B2, and B3.

In addition, since the capacity of each of the plurality of batteries B1, B2, and B3 is estimated by the battery capacity estimating apparatus 100, the degree of degradation of each of the plurality of batteries B1, B2, and B3 may also be estimated. For example, the degree of degradation of each of the plurality of batteries B1, B2, and B3 may be estimated by comparing the design capacity with the current capacity. As such, according to the battery capacity estimating apparatus 100, since the capacity and the degree of degradation of each of the plurality of batteries B1, B2, and B3 included in the battery pack may be estimated, the state of each battery may be diagnosed more accurately.

The control unit 120 provided in the battery capacity estimating apparatus 100 may selectively include, for example, a processor, an application-specific integrated circuit (ASIC), various chipsets, logic circuitry, registers, a communication modem, and a data processing device, which are well known in the art, in order to execute various control logics performed in the present disclosure. When the control logics are implemented in software, the control unit 120 may be implemented as a set of program modules. In this case, the program modules may be stored in memory and executed by the control unit 120. The memory may be located inside or outside the control unit 120 and may be connected to the control unit 120 by various well-known means.

The battery capacity estimating apparatus 100 may further include a storage unit 130. The storage unit 130 may store data or programs required for each component of the battery capacity estimating apparatus 100 to perform operations and functions, as well as data generated during the execution of operations and functions. The storage unit 130 is not particularly limited in type as long as it is a well-known information storage means capable of recording, erasing, updating, and reading data. As an example, the information storage means may include, for example, random access memory (RAM), flash memory, read-only memory (ROM), electronically erasable programmable read-only memory (EEPROM), and a register. In addition, the storage unit 130 may store program codes defining processes executable by the control unit 120.

For example, information regarding the pack capacity Qp of the battery pack measured by the measurement unit 110 and the voltages of the plurality of batteries B1, B2, and B3 may be stored in the storage unit 130. Then, the control unit 120 may access the storage unit 130 to acquire information used to estimate the capacity of the plurality of batteries B1, B2, and B3.

Hereinafter, an embodiment in which the control unit 120 calculates the change ratio of each of the plurality of batteries B1, B2, and B3 will be described.

According to an embodiment, the control unit 120 may calculate the change ratio of each of the plurality of batteries B1, B2, and B3 by adjusting the size of the plurality of voltage ranges to correspond to the range size of a preset reference voltage range.

First, the control unit 120 may be configured to calculate a range value representing the size of each of the plurality of voltage ranges. For example, the control unit 120 may calculate the difference between the first voltage and the second voltage of a voltage range to calculate the range value of the voltage range.

In the embodiment of FIG. 2, the control unit 120 may calculate the difference between the first voltage Vi1 and the second voltage Vf1 of the first battery B1 to calculate the range value as R1 [V]. The control unit 120 may calculate the difference between the first voltage Vi2 and the second voltage Vf2 of the second battery B2 to calculate the range value as R2 [V]. The control unit 120 may calculate the difference between the first voltage Vi3 and the second voltage Vf3 of the third battery B3 to calculate the range value as R3 [V].

Then, the control unit 120 may be configured to calculate the ratio of each of the plurality of voltage range values to a preset reference range value Rref of the reference voltage range and to calculate the change ratio of each of the plurality of batteries B1, B2, and B3.

For example, it is assumed that the reference range value of the reference voltage range is greater than the range value of the first voltage range, smaller than the range value of the second voltage range, and equal to the range value of the third voltage range. Since the range value of the first voltage range needs to be increased to correspond to the reference range value of the reference voltage range, the change ratio of the first voltage range may exceed 100%. In addition, since the range value of the second voltage range needs to be decreased to correspond to the reference range value of the reference voltage range, the change ratio of the second voltage range may be less than 100%. Furthermore, since the range value of the third voltage range is equal to the reference range value of the reference voltage range, the change ratio of the third voltage range is 100%.

In the embodiment of FIG. 2, it is assumed that one of the voltage ranges of the first to third batteries B1, B2, and B3 is set as the reference voltage range. The control unit 120 may calculate the change ratio of each of the first to third batteries B1, B2, and B3 by dividing the range value of each voltage range by the reference range value Rref of the reference voltage range. For example, the control unit 120 may calculate the equation "R1 ÷ Rref" to calculate the change ratio of the first battery B1 as CS1 [%], calculate the equation "R2 ÷ Rref" to calculate the change ratio of the second battery B2 as CS2 [%], and calculate the equation "R3 ÷ Rref" to calculate the change ratio of the third battery B3 as CS3 [%].

Hereinafter, an embodiment in which the control unit 120 calculates the relative capacity ratio of the plurality of batteries will be described.

The control unit 120 may be configured to set the largest value among the plurality of change ratios as the reference change ratio CSref.

The charging of the battery pack is completed at the point when the charging of the most degraded battery among the plurality of batteries is completed. When the charging of the battery pack is completed, the most degraded battery is fully charged, whereas the remaining batteries are not fully charged. As such, since the plurality of batteries are connected in series with each other, the pack capacity Qp of the battery pack corresponds to the capacity of the most degraded battery among the plurality of batteries.

Then, the change ratio is a value proportional to the range value, and the larger the range value, the greater the calculated value. Here, a larger range value means that the voltage change is greater during the same charging time. For example, the battery with the largest change ratio among the plurality of batteries is the most degraded battery (the battery with the smallest capacity).

For example, during the charging process of the battery pack, the charging of the most degraded battery is completed first. Thus, the range value and change ratio of the most degraded battery are larger than those of the other batteries.

Accordingly, the control unit 120 may set the largest value among the plurality of change ratios as the reference change ratio CSref.

Then, the control unit 120 may calculate the ratio of the reference change ratio CSref to the change ratio of each of the plurality of batteries to calculate the relative capacity ratio of each of the plurality of batteries.

The battery capacity estimating apparatus 100 according to an embodiment of the present disclosure may estimate the capacity of each of the remaining batteries based on the capacity of the most degraded battery (pack capacity Qp) by setting the largest value among the plurality of change ratios as the reference change ratio CSref. As such, the battery capacity estimating apparatus 100 has the advantage of being able to accurately estimate the capacity of plurality of batteries by considering the charging-discharging characteristics of batteries connected in series with each other.

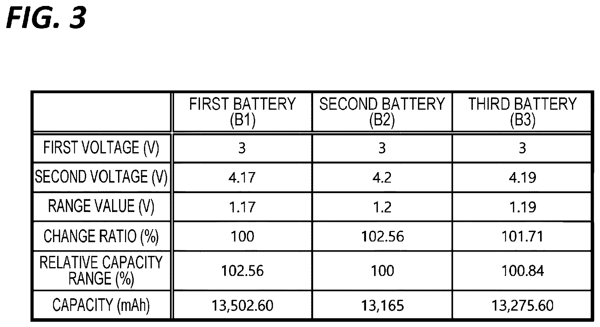

FIG. 3 is a view illustrating the capacities of the first to third batteries B1, B2, and B3 according to an embodiment of the present disclosure in more detail.

The first voltage of the first battery B1 is 3 [V], the second voltage is 4.17 [V], and the range value is 1.17 [V].

The first voltage of the second battery B2 is 3 [V], the second voltage is 4.2 [V], and the range value is 1.2 [V].

The first voltage of the third battery B3 is 3 [V], the second voltage is 4.19 [V], and the range value is 1.19 [V].

The pack capacity Qp of the battery pack is 13,165 mAh.

The control unit 120 may set the range value of the first battery B1 (1.17 [V]) as the reference range value Rref among the range values of the first to third batteries B1, B2, and B3 and calculate the ratio of each range value to the reference range value Rref to calculate the change ratio of the first to third batteries B1, B2, and B3. Here, the reference range value Rref is arbitrarily set among the range values of the first to third batteries B1, B2, and B3 and may also be set as the range value of the second battery B2 or the third battery B3.

For example, the control unit 120 may calculate the equation "1.17 ÷ 1.17" to calculate the change ratio of the first battery B1 as 100%. The control unit 120 may calculate the equation "1.2 ÷ 1.17" to calculate the change ratio of the second battery B2 as 102.56%. The control unit 120 may calculate the equation "1.19 ÷ 1.17" to calculate the change ratio of the third battery B3 as 101.71%.

Next, since the change ratio of the second battery B2 is the largest at 102.56%, the control unit 120 may set the change ratio of the second battery B2 as the reference change ratio CSref and calculate the ratio of the reference change ratio CSref to each change ratio to calculate the relative capacity ratio of the first to third batteries B1, B2, and B3.

For example, the control unit 120 may calculate the equation "102.56 ÷ 100" to calculate the relative capacity ratio of the first battery B1 as 102.56% and calculate the equation "102.56 ÷ 102.56" to calculate the relative capacity ratio of the second battery B2 as 100%. The control unit 120 may calculate the equation "102.56 ÷ 101.71" to calculate the relative capacity ratio of the third battery B3 as 100.84%. The capacity of the first battery B1 is larger than the capacity of the second battery B2 by 2.56%, and the capacity of the third battery B3 is larger than the capacity of the second battery B2 by 0.84%.

The control unit 120 may calculate the capacity of each of the plurality of batteries by multiplying the pack capacity Qp of 13,165 mAh by the relative capacity ratio of each of the plurality of batteries.

For example, the control unit 120 may calculate the equation "13,165 × 102.56%" to calculate the capacity of the first battery B1 as 13,502.6 mAh. In addition, the control unit 120 may calculate the equation "13,165 × 100%" to calculate the capacity of the second battery B2 as 13,165 mAh. The control unit 120 may calculate the equation "13,165 × 100.84%" to calculate the capacity of the third battery B3 as 13,275.6 mAh.

The battery capacity estimating apparatus 100 according to the present disclosure may be applied to a battery management system (BMS). For example, the BMS according to the present disclosure may include the above-described battery capacity estimating apparatus 100. In such a configuration, at least some of the components of the battery capacity estimating apparatus 100 may be implemented by supplementing or adding functions to the components included in a conventional BMS. For example, the measurement unit 110, the control unit 120, and the storage unit 130 of the battery capacity estimating apparatus 100 may be implemented as components of the BMS.

In addition, the battery capacity estimating apparatus 100 according to the present disclosure may be provided in a battery pack. For example, the battery pack according to the present disclosure may include the above-described battery capacity estimating apparatus 100 and one or more battery cells. The battery pack may further include electrical components (e.g., a relay and a fuse) and a case.

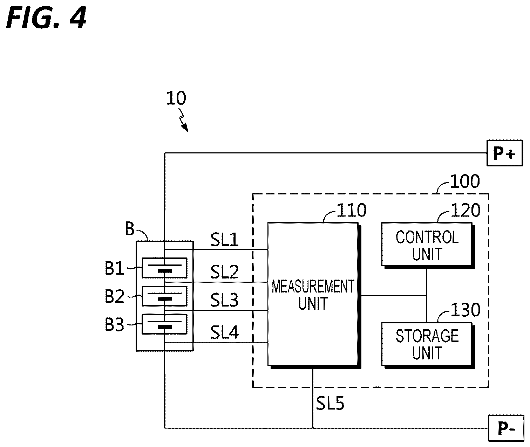

FIG. 4 is a schematic view illustrating a battery pack 10 according to another embodiment of the present disclosure.

Referring to FIG. 4, the battery pack 10 may include a plurality of batteries B. The plurality of batteries B include a first battery B1, a second battery B2, and a third battery B3. According to an embodiment, the first battery B1, the second battery B2, and the third battery B3 may be connected in series with each other.

The positive electrode terminal of the first battery B1 may be connected to the positive electrode terminal P+ of the battery pack 10, and the negative electrode terminal of the third battery B3 may be connected to the negative electrode terminal P- of the battery pack 10.

The measurement unit 110 may be connected to first to fifth sensing lines SL1 to SL5.

For example, the measurement unit 110 may measure the voltage of the first battery B1 through the first sensing line SL1 and the second sensing line SL2. In addition, the measurement unit 110 may measure the voltage of the second battery B2 through the second sensing line SL2 and the third sensing line SL3. The measurement unit 110 may measure the voltage of the third battery B3 through the third sensing line SL3 and the fourth sensing line SL4.

In addition, the measuring unit 110 may be connected to a current measurement unit A via the third sensing line SL5. According to an embodiment, the current measurement unit A may be an ammeter or a shunt resistor capable of measuring the charging current and discharging current of the plurality of batteries B. The measurement unit 110 may measure the charging current of the plurality of batteries B through the fifth sensing line SL5 and calculate the charge amount. In addition, the measurement unit 110 may measure the discharging current of the plurality of batteries B through the fifth sensing line SL5 and calculate the discharge amount.

Meanwhile, an external device may be connected to the positive electrode terminal P+ and the negative electrode terminal P- of the battery pack 10. For example, the external device may be a charging apparatus or a load.

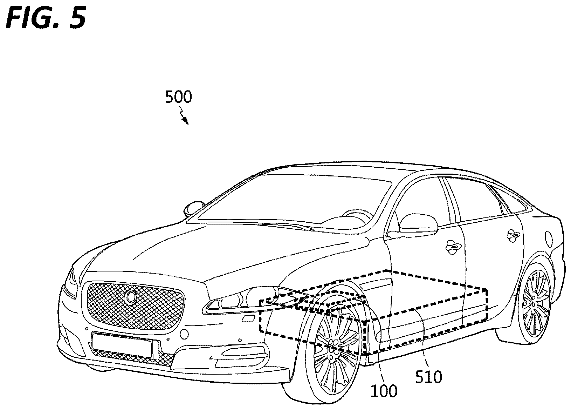

FIG. 5 is a view schematically illustrating a vehicle 500 according to another embodiment of the present disclosure.

Referring to FIG. 5, a battery pack 510 according to an embodiment of the present disclosure may be included in a vehicle 500, such as an electric vehicle (EV) or a hybrid vehicle (HV). The battery pack 510 may supply power to the motor through an inverter provided in the vehicle 500, thereby driving the vehicle 500. Here, the battery pack 510 provided in the vehicle may include the battery capacity estimating apparatus 100 according to an embodiment of the present disclosure. That is, the vehicle 500 may include the battery capacity estimating apparatus 100. In this case, the battery capacity estimating apparatus 100 may be an onboard apparatus included in the vehicle 500.

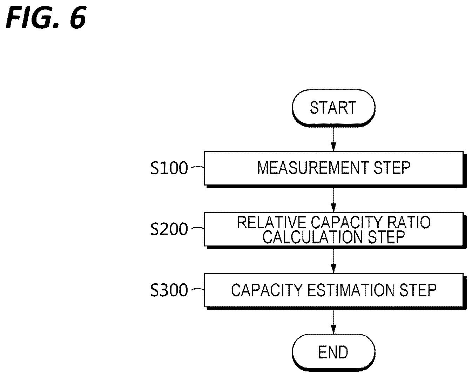

FIG. 6 is a view schematically illustrating a battery capacity estimating method according to another embodiment of the present disclosure.

Referring to FIG. 6, the battery capacity estimating method may include a measurement step (S100), a relative capacity ratio calculation step (S200), and a capacity estimation step (S300).

Each step of the battery capacity estimating method of the present disclosure may be performed by the battery capacity estimating apparatus 100. Hereinafter, for convenience of explanation, descriptions that overlap those described above will be omitted or briefly explained.

The measurement step (S100) is a step of measuring the pack capacity of the battery pack 10 and the voltage of each of the plurality of batteries B1, B2, and B3 included in the battery pack during a charging-discharging process and may be performed by the measurement unit 110.

For example, during the charging process of the battery pack, the measurement unit 110 may measure the pack capacity Qp of the battery pack and the voltage of the plurality of batteries B1, B2, and B3.

The relative capacity ratio calculation step (S200) is a step of calculating the relative capacity ratio among the plurality of batteries B1, B2, and B3 based on the voltage range of each of the plurality of batteries B1, B2, and B3 and may be performed by the control unit 120.

The control unit 120 may be configured to determine the voltage range of each of the plurality of batteries B1, B2, and B3 based on the voltage of each battery measured by the measurement unit 110.

Then, the control unit 120 may set one of the range values of the plurality of batteries B1, B2, and B3 or the average value of the range values of the plurality of batteries B1, B2, and B3 as the reference range value Rref. The control unit 120 may calculate the ratio of each range value to the reference range value Rref to calculate the change ratio of each of the plurality of batteries B1, B2, and B3.

The control unit 120 may set one of the plurality of change ratios as the reference change ratio CSref. According to an embodiment, the control unit 120 may set the largest value among the plurality of change ratios as the reference change ratio CSref.

Then, the control unit 120 may be configured to calculate the ratio of the reference change ratio CSref to each change ratio to calculate the relative capacity ratio of each of the plurality of batteries B1, B2, and B3.

The capacity estimation step (S300) is a step of estimating the capacity of each of the plurality of batteries B1, B2, and B3 based on the pack capacity Qp and the relative capacity ratio and may be performed by the control unit 120.

The control unit 120 may be configured to estimate the capacity of each of the plurality of batteries B1, B2, and B3 by multiplying the pack capacity Qp by the relative capacity ratio of each battery.

The above-described embodiments of the present disclosure are not limited to being implemented solely through apparatuses and methods, but may also be implemented through a program that realizes the functions corresponding to the configuration of the embodiments of the present disclosure or through a recording medium on which such a program is recorded. This may be readily implemented by a person ordinarily skilled in the technical field to which the present disclosure belongs based on the description of the embodiments described above.

While the present disclosure has been described above with reference to several embodiments and drawings, the present disclosure is not limited thereto, and various changes and modifications can be made by a person ordinarily skilled in the art to which the present disclosure pertains without departing from the technical spirit of the present disclosure and the equivalent scope of the claims to be described below.

In addition, since various substitutions, modifications, and changes can be made to the present disclosure as described above without departing from the technical spirit of the present disclosure by a person ordinarily skilled in the art to which the present disclosure pertains, the present disclosure is not limited to the above-described embodiments and the accompanying drawings, but all or some of the respective embodiments can be selectively combined so that various modifications can be made.

### Description of symbol

1: battery pack
B: a plurality of batteries
B1: first battery
B2: second battery
B3: third battery
100: battery capacity estimating apparatus
110: measurement unit
120: control unit
130: storage unit
500: vehicle
510: battery pack

## Claims

1. A battery capacity estimating apparatus comprising:
a measurement unit configured to measure a pack capacity of a battery pack and a voltage of each of a plurality of batteries included in the battery pack during a charging-discharging process; and
a control unit configured to calculate a relative capacity ratio among the plurality of batteries based on a voltage range of each of the plurality of batteries, and estimate a capacity of each of the plurality of batteries based on the pack capacity and the relative capacity ratio.

2. The battery capacity estimating apparatus according to claim 1,
wherein the control unit is configured to: determine the voltage range of each of the plurality of batteries; adjust the determined plurality of voltage ranges to correspond to each other to calculate a change ratio of each of the plurality of batteries; and calculate the relative capacity ratio of each of the plurality of batteries based on the calculated plurality of change ratios.

3. The battery capacity estimating apparatus according to claim 2,
wherein the control unit is configured to set one of the plurality of voltage ranges as a reference voltage range, and adjust the plurality of voltage ranges to correspond to the reference voltage range to calculate the plurality of change ratios.

4. The battery capacity estimating apparatus according to claim 3,
wherein the control unit is configured to calculate a range value representing a size of each of the plurality of voltage ranges, and calculate a ratio of a range value of the reference voltage range to the range value of each of the plurality of voltage ranges to calculate the plurality of change ratios.

5. The battery capacity estimating apparatus according to claim 2,
wherein the control unit is configured to set one of the plurality of change ratios as a reference change ratio, and calculate the relative capacity ratio of each of the plurality of batteries based on the plurality of change ratios and the reference change ratio.

6. The battery capacity estimating apparatus according to claim 5,
wherein the control unit is configured to calculate a ratio of the reference change ratio to each of the plurality of change ratios to calculate the relative capacity ratio of each of the plurality of batteries.

7. The battery capacity estimating apparatus according to claim 5,
wherein the control unit is configured to set a largest value among the plurality of change ratios as the reference change ratio.

8. The battery capacity estimating apparatus according to claim 1,
wherein the control unit is configured to estimate the capacity of each of the plurality of batteries by multiplying the pack capacity by the relative capacity ratio.

9. The battery capacity estimating apparatus according to claim 1,
wherein the plurality of batteries are configured to be connected in series with each other.

10. A battery pack comprising the battery capacity estimating apparatus according to any one of claims 1 to 9.

11. A vehicle comprising the battery capacity estimating apparatus according to any one of claims 1 to 9.

12. A battery capacity estimating method comprising:
a measurement step of measuring a pack capacity of a battery pack and a voltage of each of a plurality of batteries included in the battery pack during a charging-discharging process;
a relative capacity ratio calculation step of calculating the relative capacity ratio among the plurality of batteries based on a voltage range of each of the plurality of batteries; and
a capacity estimation step of estimating a capacity of each of the plurality of batteries based on the pack capacity and the relative capacity ratio.

13. A non-transitory computer-readable storage medium having stored therein a program for executing a battery capacity estimating method comprising:
a measurement step of measuring a pack capacity of a battery pack and a voltage of each of a plurality of batteries included in the battery pack during a charging-discharging process;
a relative capacity ratio calculation step of calculating the relative capacity ratio among the plurality of batteries based on a voltage range of each of the plurality of batteries; and
a capacity estimation step of estimating a capacity of each of the plurality of batteries based on the pack capacity and the relative capacity ratio.
